# EUROPÄISCHE PATENTSCHRIFT

(11) **EP 1 306 463 B1**
(45) Veröffentlichungstag und Bekanntmachung des Hinweises auf die Patenterteilung: **22.09.2010**
(21) Anmeldenummer: 02022508.2
(22) Anmeldetag: 07.10.2002
(51) Int. Cl.: C23C 14/50, C23C 16/458, C23C 14/54

(54) **Plattenträger**
Holder for plates
Support de disques

(30) Priorität: 23.10.2001 CH 19452001
(43) Veröffentlichungstag der Anmeldung: 02.05.2003
(73) Patentinhaber: Oerlikon Trading AG, Trübbach, 9477 Trübbach (CH)
(72) Erfinder: Voser, Stephan, 9479 Buchs (CH); Dubs, Martin, 9477 Trübbach (CH)
(74) Vertreter: Wegmann, Urs

(56) Entgegenhaltungen:
- US-A- 4 615 755
- PATENT ABSTRACTS OF JAPAN vol. 2000, no. 03, 30. März 2000 (2000-03-30) & JP 11 350133 A (MATSUSHITA ELECTRIC IND CO LTD), 21. Dezember 1999 (1999-12-21)

## Beschreibung

Die Erfindung betrifft einen Speicherplattenträger gemäss dem Oberbegriff des Patentanspruches 1 sowie die Verwendung eines Speicherplattenträgers zur Bearbeitung von optischen Speicherplatten nach Anspruch 9.

Die Oberflächenbearbeitung von Speicherplatten für die Informationstechnologie erfolgt heute bei der Herstellung solcher Platten vorwiegend mit Prozessen in Vakuumsystemen. Behandelt werden hierbei Speicherplatten für magnetische Speichertechniken wie auch optische Speichersysteme. Für die Bearbeitung der Oberflächen werden oft Plasmavakuumprozesse eingesetzt, wie beispielsweise zum Ätzen der Oberfläche, Aktivieren der Oberfläche, Reinigung der Oberfläche und insbesondere Abscheiden von Schichten auf die Platte. Als Beschichtungsprozess wird heute vorwiegend der weit verbreitete Zerstäubungsprozess, auch bekannt als Sputtern, eingesetzt. Besonders vorteilhaft werden heute die Platten einzeln nacheinander im Takt, in kompakten Anlagen, beschichtet. Die Taktzeiten sind hierbei im Sekundenbereich, um hohe Durchsätze zu erzielen wegen der erforderlichen Wirtschaftlichkeit.

Die Platten, auf welche Schichten aufgebracht werden, sind bei magnetischen Speicherplatten in der Regel aus Metall oder Glas, wobei bei optischen Speicherplatten bevorzugt Kunststoffmaterialien verwendet werden. Vor allem beim Zerstäubungsvorgang, wo ein Zerstäubungstarget bei einem Abstand von wenigen Zentimetern von der Platte mit Hilfe eines Plasmaprozesses zerstäubt wird, ist die Beschichtung der Platte bzw. der Disc im allgemeinen mit einem recht hohen Wärmeeintrag verbunden, insbesondere da bei den kurzen geforderten Taktzeiten hohe Abscheideraten notwendig sind. Die Wärmebelastung ist vor allem bedingt durch Elektronenbeschuss, Wärmestrahlung und kinetische sowie Kondensationsund Anregungsenergie des Beschichtungsmaterials. Dies führt insbesondere bei Kunststoffplatten beziehungsweise Substraten und vor allem bei dünnen Platten mit einer kleinen Wärmekapazität, zu einer Temperaturerhöhung der Platte, falls diese Wärmeenergie nicht hinreichend abgeführt wird. In solchen Fällen kann sich vor allem die Kunststoffplatte, welche typischerweise aus Polykarbonat besteht plastisch verformen, so dass sie unbrauchbar wird. Die Einhaltung einer zulässigen Maximaltemperatur und das Erzielen einer gleichmässigen Temperaturverteilung über die Platte sind wesentliche Kriterien für das Erzielen einer guten Speicherplattenqualität.

Es ist allgemein bekannt, dass die Wärmeübertragung im Vakuum sehr schlecht ist. Dies vor allem bei geringen Temperaturdifferenzen, beispielsweise von < 100 °C, wie sie bei diesen Anwendungen erreicht werden sollten. Eine Möglichkeit zur Kühlung der Platte besteht darin, den Beschichtungsprozess in verschiedenen Prozessstationen sequentiell ablaufen zu lassen und eine oder mehrere Kühlstationen dazwischen zu schalten, die die Platte vor Erreichen der Maximaltemperatur zwischen den Beschichtungsstationen abkühlt. Der Wärmeübergang zwischen einer gekühlten Fläche und der Rückfläche der Platte kann hierbei mittels eines Wärmeübertragungsmediums, wie beispielsweise Helium, verbessert werden. Kurze Abstände oder gar das Aufliegen der Flächen sind hierbei vorteilhaft und der Druck des Gases wird hierbei in der Kühlstation bis in den mbar-Bereich erhöht. Zusätzlich wurde versucht, die Platte mit Hilfe elektrostatischer Anziehung an eine gekühlte Fläche anzupressen und zusätzlich den Wärmeübergang mittels eines Gaspolsters zu verbessern. Es wurde ausserdem versucht, bei biegesteifen flachen plattenförmigen Substraten oder Werkstücken diese am Rand festzuhalten und eine sphärisch gewölbte Fläche zu spannen, wobei ebenfalls ein Anpressdruck erzeugt wird, der auch eine Gaskühlung an der Rückseite ermöglicht, wie dies beispielsweise in der US 4,615,755 offenbart ist. Neben der Verbesserung des Wärmeüberganges mit Hilfe von Gasen wurden auch Kontaktmaterialien eingesetzt wie Zinnfolien, Elastomere, oder gar pastenförmige Materialien.

Eine ähnliche Anordnung wie in der zuvor beschriebenen US 4,615,755 wird in der Japanischen Offenlegungsschrift JP 11-350133A offenbart. Dort handelt es sich allerdings weder um eine Kühl- noch um eine Heizvorrichtung für ein Substrat. In dieser Schrift wird das Problem von flachen, scheibenförmigen Substraten angesprochen, welche sich unerwünscht deformieren bei einem Beschichtungsprozess. Zur Lösung wird vorgeschlagen das Substrat vorab derart in entgegengesetzte Richtung zu deformieren, dass die zu erwartende Verformung durch den Prozess kompensiert wird. Dazu soll das scheibenförmige Substrat an dessen Peripherie entsprechend stark über eine etwa sphärische, kontinuierlich gebogene Fläche gespannt werden, wodurch eine Verbiegung eingestellt wird, die nachher beim Prozess kompensiert werden soll. Die Verbiegeanordnung ist ähnlich ausgebildet, wie sie in der vorerwähnten US - Patentschrift beschrieben worden ist. Der Substrathalter weist hierbei im Zentrum ebenfalls eine Erhöhung auf welche gegen den Rand hin kontinuierlich abfällt.

Der Einsatz von separaten Kühlstationen zwischen den Prozessstationen erfordert einen erheblichen technischen Aufwand. Ausserdem ist die Kühlzeit auf einen Bruchteil der gesamten Prozesszeit des Substrats beschränkt, was wiederum eine gute Wärmeübertragung durch eine hohe Wärmeleitfähigkeit und / oder eine unter Raumtemperatur gekühlte Kühlfläche erfordert.

Eine elektrostatische Anziehung des Substrats ist insbesondere bei nicht leitenden Substraten schwierig zu realisieren und bewirkt Anpressdrücke, welche bedeutend kleiner sind als die bei leitenden Substraten erzielbaren Anpressdrücke. Dies könnte durch eine leitende Beschichtung der Substrate auf der Rückseite oder Erzeugen einer minimal notwendigen Leitfähigkeit im Substrat durch geeignete Dotierung erfolgen. Insbesondere bei optischen Discs ist dies aber nicht erwünscht, da abgesehen von den höheren Substratkosten damit auch die optischen Eigenschaften des Substrats in ungünstiger Weise beeinträchtigt werden können. Das Einspannen des Substrats am Aussenrand und Aufspannen auf eine sphärische oder zylinderförmige Fläche verursacht wegen des hohen notwendigen Spannbereiches Spannungen im Substratmaterial derart, dass dieses plastisch verformt werden kann. Ausserdem wird wegen des grossen Spannbereichs die Oberflächenform des Substrates derart verändert, dass dadurch die Gleichmässigkeit der Beschichtung beeinträchtigt wird.

Die vorliegende Erfindung hat es sich zur Aufgabe gemacht, die Nachteile des Standes der Technik zu beseitigen. Insbesondere ist es Aufgabe der vorliegenden Erfindung ein Substrat mit einem vorgegebenen Anpressdruck in Kontakt mit einer Kühlfläche zu bringen, derart dass der Anpressdruck möglichst gleichmässig über die Oberfläche verteilt ist und ein gleichmässiger Wärmekontakt auftritt. Hierbei soll das Substrat einer minimalen Biegebeanspruchung und minimaler Verformung der Oberfläche unterworfen sein, ohne dass das Substrat eine plastische Verformung erleidet und eine gleichmässige Beschichtung ermöglicht wird.

Diese Aufgabe wird erfindungsgemäss durch die Merkmale des Anspruches 1 gelöst. Weitere vorteilhafte Ausführungsformen beinhalten die abhängigen Patentansprüche. Erfindungsgemäss wird ein Speicherplattenträger im Bereich der Auflagefläche für die Speicherplatte ringförmig konvex gewölbt ausgebildet, derart dass die Speicherplatte sowohl im Zentrum wie auch an deren Aussenrand über diese ringförmig konvex ausgebildete Auflagefläche gespannt werden kann. Die Speicherplatte nimmt dadurch in ihrem befestigten Zustand die leicht gewölbte, konvexe Form der Auflagefläche an. Dadurch, dass diese Art Speicherplatten im Zentrum eine Öffnung aufweisen, können diese Platten sowohl im Zentrum wie auch entlang dem Aussenrand über eine Halterung, welche gleichzeitig als Maske ausgebildet ist zur dortigen Verhinderung von Beschichtung, auf diese Weise gespannt werden. Diese ringförmige, torusartige Verwölbung der Platte führt zu einer wesentlich steiferen Anordnung bei höheren und gleichmässiger verteilten Anpressdrücken über die Fläche als dies gemäss Stand der Technik möglich war und dies gleichzeitig bei wesentlich geringerer erforderlicher Durchbiegung. Hierdurch wird die Platte weniger verformt und gleichzeitig hat diese geringe Verformung keinen negativen Einfluss mehr auf die Schichtdickenverteilung der Beschichtung.

Die konvexe Biegelinie muss nicht zwingend sphärisch sein. Diese kann beispielsweise bedingt durch den Temperaturgradienten zwischen Vorder- und Rückseite des Substrats während der Beschichtung ebenfalls bei der Form der Anpressfläche durch zusätzliche Krümmungsformen berücksichtigt werden. Insbesondere wegen der einfachen und nun definierten einhaltbaren Geometrie ist die Wölbung somit eindeutig bestimmt durch die Randbedingungen am Substrat, wie äussere und innere Auflage, respektive Einspannbedingung, Druckkräfte auf die Rückseite und thermische Biegekräfte durch Temperaturgradienten im Substrat. Der Fachmann kann nun die bekannten Verfahren zur Berechnung der notwendigen Verformung, wie analytische oder finite Elemente Rechenmethoden, zur Anwendung bringen.

Neben der Form der Auflagefläche kann auch zusätzlich durch ein Gaspolster, bevorzugt mit einem Gas hoher Wärmeleitung wie zum Beispiel Helium, der Wärmekontakt weiter verbessert werden. Dabei sollte der maximale Gasdruck unter dem Anpressdruck liegen. Ausserdem sind zusätzlich duktile Metallfolien, beispielsweise Zinn enthaltende Folien, oder Elastomere Folien mit der Erfindung vorteilhaft kombinierbar. Der Speicherplattenträger kann sowohl zum Heizen wie auch zum Kühlen eingesetzt werden, wenn dieser entsprechend mit Mitteln dafür ausgerüstet ist. Vorteilhafterweise wird die Anordnung aber zum Kühlen von optischen Speicherplatten eingesetzt. Hierzu ist der Speicherplattenträger beispielsweise als Kupferkonstruktion ausgebildet, welcher Kühlkanäle enthält, die mit einem Kühlmedium wie mit Kühlwasser durchflossen sind.

Die Anordnung ist besonders geeignet für den Einsatz von optischen Speicherplatten aus Kunststoff, insbesondere aus Polykarbonat. Solche Speicherplatten sind bekannt unter dem Begriff Compactdisc (CD) und Digital Versatile Disc (DVD). Selbstverständlich fallen darunter auch alle abgewandelten Arten wie CD-R, CD-RW, DVD-R, DVD-RW, DVD+RW,DVD-RAM, das heisst alle beschreibbaren und wiederbeschreibbaren Ausführungen. Insbesondere die DVD's sind besonders problematisch in der Handhabung, da die DVD's aus etwa halb so dicken Substraten wie die CD's hergestellt werden, nämlich im Bereich von 0,6 mm Dicke. Bei diesen Dicken sind die thermischen Einflüsse besonders kritisch.

Die Erfindung wird nun anhand eines typischen Ausführungsbeispiels zur Kühlung von wiederbeschreibbaren DVD's beschrieben. Zur Herstellung von solchen DVD's werden typischerweise zwei Substrate aus Polykarbonat, welche 0,6 mm dick sind und einen Durchmesser von 120 mm aufweisen, hergestellt und anschliessend miteinander verklebt. Die kreisrunden Substrate weisen im Zentrum ein Innenloch mit einem Innenlochdurchmesser von 15 mm auf. Die Beschichtung erfolgt in einer Vakuumzerstäubungsanlage, wobei das Schichtpaket beispielsweise folgends Schichten umfasst: zuerst substratseitig eine Schicht aus ZnS:SiO₂, dann die optische Aufzeichnungsschicht, ein sogenanntes Phase Change Material wie beispielsweise TeGeSb, dann eine ZnS:SiO₂-Schicht und zuletzt eine mindestens teilreflektierende Aluminiumschicht mit einer Schichtdicke im Bereich von 100-300 nm. Die Beschichtung von solchen Schichtsystemen erfolgt typischerweise in einer Mehrkammeranlage mit beispielsweise sechs Prozesskammern, wobei die totale Beschichtungszeit 30 bis 60 s dauert. Der Wärmeeintrag während der Beschichtung ist ca. 10 J/cm² oder rund 1 kJ für die ganze Disc. Die Maximaltemperatur der Disc sollte möglichst tief gehalten werden, um plastische Verformungen der Disc zu vermeiden, idealerweise sollte die Disctemperatur unter 50 °C liegen. Sowohl die Aussenmaske wie die Innenmaske werden während der Beschichtung in der Regel magnetisch auf einem flachen Substratträger gemäss Stand der Technik gehalten. Während der Beschichtung erwärmt sich die Vorderseite der Disc durch den bei der Beschichtung auftretenden Wärmestrom gegenüber der Rückseite um rund 10 °C, was die Disc um rund 0,3 mm aufwölbt. Dadurch wird der Wärmekontakt zum Substratträger praktisch unterbrochen. Die Disc wird nur ganz aussen und ganz innen gekühlt und verformt sich unzulässig durch die ungleichmässige Temperaturbelastung im plastischen Bereich, auch wenn der flache Speicherplattenträger aus gut wärmeleitendem Material, wie Kupfer besteht und gut gekühlt ist.

Vergleichsweise weist nun die erfindungsgemässe Ausführung die konvex geformte und toroidartig gewölbte Auflagefläche des Speicherplattenträgers auf. Der Speicherplattenträger ist vorzugsweise ebenfalls eine Kupferkonstruktion und ist auf gleiche Weise gekühlt wie der vorher beschriebene Träger. Die Aufwölbung des Trägers ist bei diesem Beispiel 1 mm. Im übrigen wurde die selbe DVD-Platte bearbeitet unter den gleichen Bedingungen. Die Aufwölbung von 1 mm führt zu einem Anpressdruck von ca. 15 mbar bei einer kalten Speicherplatte. Die hierbei in der Disc auftretenden Zug- und Druckspannungen liegen dabei bei maximal 7 MPa, gemäss Definition nach van Mises (Dubbel, Taschenbuch für Maschinenbau, 14. Auflage, S. 228) Vergleichsspannungen berechnet mit finiten Elementen. Während der Beschichtung erwärmt sich die Vorderseite der Disc durch den bei der Beschichtung auftretenden Wärmestrom gegenüber der Rückseite um rund 10 °C, was den Anpressdruck und somit auch die Plattenspannungen leicht reduziert. Zum Vergleich sei noch die Durchbiegung bei einer nur am Rand eingespannten Disc angegeben. Um einen Anpressdruck von 15 mbar zu erreichen, muss hierbei eine Durchbiegung von 3 mm erzeugt werden, wobei rund 1 mm durch die thermische Belastung schon alleine auftritt. Die stärkere Wölbung bewirkt auch eine grössere Schichtdickenabweichung bei der Beschichtung als bei der erfindungsgemässen Einspannungsart innen und aussen.

Ohne Kühlung erwärmt sich die Disc um rund 100 °C, wobei sie sich nach dem Abkühlen in unzulässiger Weise verzieht. Mit einem flachen Speicherplattenträger beträgt die Disctemperatur beim Entladen aus der Anlage ca. 85 °C. Es erfolgt wohl eine gewisse Kühlung, wobei ein Wärmeübergangskoeffizient zwischen Disc und Träger von rund 50 W/K/m² abgeschätzt werden kann. Mit dem erfindungsgemässen Speicherplattenträger liegt die Disctemperatur nach der Beschichtung bei ca. 45 °C. Die Temperaturerhöhung beträgt hier also nur ca. 25 °C gegenüber Umgebungstemperatur. Mit dem erfindungsgemässen Speicherplattenträger wird somit ein Wärmeübergangskoeffizient von ca. 150 W/K/m² erzielt. Es konnte auch überraschenderweise festgestellt werden, dass durch das Ausgasen von Kunststoffsubstraten eine Art Gaspolster erzeugt wird zwischen Plattenrückseite und Speicherplattenträgerauflagefläche, womit eine zusätzliche Verbesserung der Wärmeübertragung ermöglicht wird.

Durch die ringförmig konvex geformte Ausbildung der Auflagefläche des Speicherplattenträgers und durch die Halterung der Platte am Aussenrand und Innenrand entsteht ein gleichmässiger Anpressdruck zwischen Platte und Speicherplattenträger, welcher auch bei thermischer Belastung durch Beschichten mit Sputterquellen aufrecht erhalten wird. Hierdurch wird eine ausreichende Kühlung der Speicherplatte über den Speicherplattenträger ermöglicht. Der gleichmässige Anpressdruck bewirkt eine ebenfalls gleichmässige Kühlung der Speicherplatte und vermeidet damit thermische Radial- und Tangentialspannungen, welche die Speicherplatte nach dem Abkühlen in einen plastisch verformten Zustand bringen würde. Die Aufwölbung des erfirdungsgemässen Speicherplattenträgers ist derart gering, dass sie nur wenig von einer flachen Auflagefläche abweicht. Hierdurch wird nicht nur eine unzulässige Verspannung der Speicherplatte vermieden, es wird auch die ungünstige Beeinflussung der Schichtdickenverteilung beim Zerstäubungsprozess weitgehend vermieden.

Die Erfindung wird anschliessend beispielsweise anhand von schematischen Figuren erläutert:
- Fig. 1: ein Speicherplattenträger mit Speicherplatte gehalten durch eine Zentralmaske und eine Aussenmaske gemäss Stand der Technik im Querschnitt
- Fig. 2: ein konvex gewölbter Speicherplattenträger gemäss Stand der Technik im Querschnitt
- Fig. 3: ein erfindungsgemässer Speicherplattenträger mit ringförmig konvex geformter Auflagefläche mit Speicherplatte gehalten durch eine Zentralmaske und eine Aussenmaske

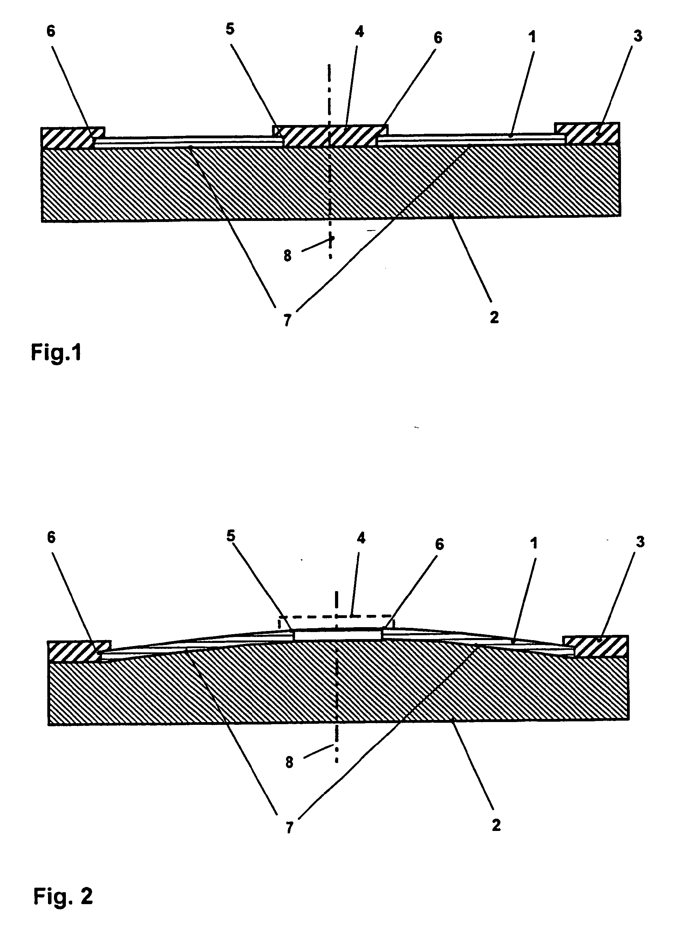

In Fig. 1 ist im Querschnitt ein Speicherplattenträger 2 dargestellt zur Aufnahme einer Speicherplatte 1 mit einer planen Auflagefläche 7 wie dies gemäss Stand der Technik üblich war. Speicherplatten sind plane scheibenförmige Körper zur Aufnahme von elektronischen Daten. Daten können in die Speicherplatte 1 beziehungsweise das Plattensubstrat eingeprägt sein oder aber in funktionalen Schichten, welche auf die Substrate 1 aufgebracht werden, gespeichert werden. Speicherplatten 1 können auch, wie dies bei DVD's üblich ist, mehrlagig aufgebaut werden. Zum Ein- und Auslesen der Daten werden solche Platten um ihre Zentrumsachse 8 rotiert. Solche Speicherplatten 1 weisen deshalb immer im Zentrum eine Öffnung 5 auf, an welcher die Platte gehalten werden kann. Bei der Beschichtung muss sowohl der Innenrandbereich 6 bei der zentralen Plattenöffnung 5 wie auch der Plattenrand 6 definiert von einer Beschichtung abgegrenzt werden. Deshalb wird im Zentrum eine Zentralmaske 4 angeordnet und am Plattenrand 6 eine Aussenmaske 3, wobei beide Masken gleichzeitig als Plattenhalterungen dienen, wie dies auch aus Fig. 1 ersichtlich ist.

Zur Verbesserung des Wärmeübergangs wurde gemäss Stand der Technik bereits vorgeschlagen, die Trägerplatte 2 konvex zu wölben, wobei die Aussenmaske 3, welche gleichzeitig als Halterung wirkt, die Speicherplatte 1 gegen die gewölbte Auflagefläche 7 des Speicherplattenträgers 2 spannt. Hierdurch wird die Speicherplatte 1 verwölbt und passt sich der konvexen Form der Auflagefläche 7 an. Um geeignete Anpressdrücke zu erzielen, muss bei dieser Ausführungsform die Speicherplatte 1 um mehrere Millimeter verwölbt werden, was zu grossen Verspannungen führt und bei der Schichtdickenverteilung negative Auswirkungen zeigt.

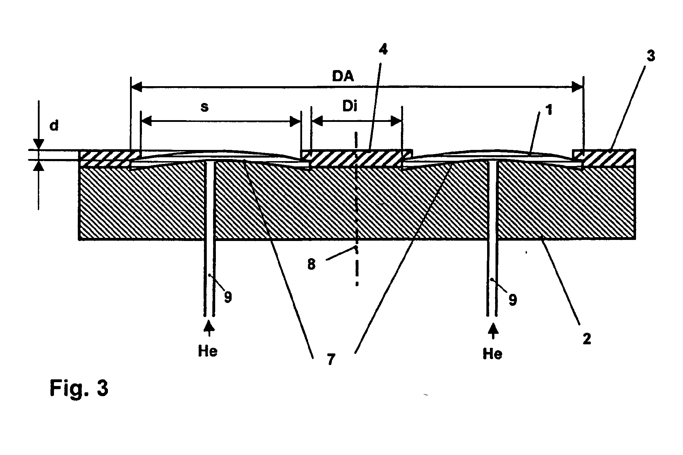

Erfindungsgemäss wird die Auflagefläche 7 des Speicherplattenträgers 2 zur Verbesserung des Wärmeüberganges ringförmig, konvex gewölbt ausgebildet um die Zentrumsachse 8. Die Speicherplatte 1 wird sowohl im Zentrum, wie auch am Rand mit den Masken 3,4 an die Auflagefläche 7 anliegend verspannt. Diese Art der Verspannung der Speicherplatte 1 ermöglicht einen guten Wärmeübergang von der Speicherplatte 1 auf den Speicherplattenträger 2, ohne dass eine grosse Verwölbung d, welche die Speicherplatte 1 schädigen würde, notwendig ist. Für die bevorzugten optischen Speicherplatten 1 aus Kunststoff, wie insbesondere für die besonders geeigneten dünnen Platten, wie DVD's 1, sind Verwölbungen d von 0,1 mm bis 2.0 mm geeignet, wobei besonders der Bereich von 0,5 mm bis 1,5 mm bevorzugt wird. Hierbei kann der erfindungsgemässe Speicherplattenträger 2 vor allem für Speicherplattendurchmesser DA eingesetzt werden, welche im Bereich von 20 bis 150 mm Durchmesser liegen, wobei besonders gute Resultate bei Plattendurchmessern DA im Bereich von 50 bis 130 mm erzielt werden. Aus Fig. 3 ist ebenfalls ersichtlich, wie die Maskierung der Zentralmaske 4 und die Maskierung der Aussenmaske 3 in Bezug auf die Speicherplatte durch leichtes Übergreifen der Plattenränder wirkt, indem die ringförmigen Ränder abgedeckt werden, womit für die Beschichtung eine definierte ringförmige zu beschichtende Wirkfläche S definiert wird. Zur weiteren Verbesserung des Wärmeübergangs ist es wie erwähnt möglich zusätzlich ein Gas zwischen die Speicherplatte 1 und die Auflagefläche 7 des Plattenträgers 2 einzuführen, wie dies schematisch mit den Gaseinlasskanälen 9 angedeutet ist. Als Kontaktgas eignen sich besonders gut wärmeleitende Gase wie Helium.
Eine weitere Verbesserung wird durch anordnen eines Dichtungselementes in den Plattenrandbereichen 6 aussen und innen, zwischen Auflagefläche 7 und Speicherplattenrückseite, erreicht. Dadurch kann das Ausströmen des Gases in den Prozessvakuumraum verhindert oder gehemmt werden und empfindliche Plasmaprozesse werden nicht gestört.

## Patentansprüche

1. Speicherplattenträger für die Aufnahme einer scheibenförmigen Speicherplatte (1) mit einer zentralen Plattenöffnung (5), welche einer Oberflächenbehandlung in einer Vakuumanlage zu unterziehen ist, mit einer Plattenauflage, die eine Auflagefläche (7) für die Platte (1) bildet, mit einer peripher die Platte (1) gegen den Träger (2) klemmbaren Aussenmaske (3) und einer klemmbaren im Bereich der Plattenöffnung (5) angeordneten Zentralmaske (4) **dadurch gekennzeichnet, dass** die Auflagefläche (7) ringförmig um die Zentrumsachse (8) angeordnet ist, und dass diese als eine konvex geformte toroidartige aufgewölbte Auflagefläche ausgebildet ist.

2. Speicherplattenträger nach Anspruch 1 **dadurch gekennzeichnet, dass** dieser mit einer Heiz- und / oder Kühleinrichtung ausgestattet ist, vorzugsweise einer Kühleinrichtung.

3. Speicherplattenträger nach Anspruch 1 oder 2 **dadurch gekennzeichnet, dass** die konvexe Auflagefläche (7) gegenüber einer planen Auflagefläche eine Verwölbung (d) aufweist, welche im Bereich von 0,1 mm bis 2,0 mm, bevorzugt im Bereich von 0,5 mm bis 1,5 mm, liegt.

4. Speicherplattenträger nach einem der vorhergehenden Ansprüche **dadurch gekennzeichnet, dass** die klemmbare Aussenmaske (3) zur Aufnahme von Speicherplatten mit einem Aussendurchmesser (DA) im Bereich von 20 bis 150 mm ausgebildet ist, vorzugsweise für Durchmesser von 50 bis 130 mm.

5. Speicherplattenträger nach einem der vorhergehenden Ansprüche **dadurch gekennzeichnet, dass** mindestens in Teilbereichen an der Auflagefläche (7) ein duktiles und / oder elastisches Kontaktmaterial vorgesehen ist zur Vergrösserung der Kontaktflächen zwischen der Speicherplatte (1) und dem Plattenträger (2).

6. Speicherplattenträger nach Anspruch 5 **dadurch gekennzeichnet, dass** das Kontaktmaterial folienartig ausgebildet ist und aus einem Kunststoff und / oder einem Metall besteht.

7. Speicherplattenträger nach einem der vorhergehenden Ansprüche **dadurch gekennzeichnet, dass** im Plattenträger (2) mindestens ein Gaseinlasskanal (9) vorgesehen ist zur Einleitung eines Kontaktgases in den Zwischenraum, gebildet aus der Auflagefläche (7) und der Speicherplattenrückseite (1).

8. Speicherplattenträger nach Anspruch 7 **dadurch gekennzeichnet, dass** im Bereich des Aussendurchmessers (D_{A}) und / oder im Bereich des Innendurchmessers (Dᵢ) der Speicherplatte (1) ringförmige Dichtmittel an der Auflagefläche (7) angeordnet sind zur Abdichtung des Zwischenraumes.

9. Verwendung eines Speicherplattenträgers nach einem der Ansprüche 1 bis 8 zur Bearbeitung von optischen Speicherplatten (1) insbesondere für CD's, CD-R, CD-RW und vorzugsweise für DVD's, DVD-R und DVD-RW.

10. Verwendung des Speicherplattenträgers nach Anspruch 9 für optische Speicherplatten aus Kunststoff, vorzugsweise aus Polykarbonat.

## Claims

1. Storage plate holder to receive a disc-like storage plate (1) with a central plate opening (5), which is to undergo surface treatment in a vacuum plant, with a plate support that forms a support surface (7) for the plate (1), with an outer mask (3) that can clamp the plate (1) peripherally against the holder (2) and a central mask (4) arranged clampable in the area of the plate opening (5), **characterised in that** the support surface (7) is arranged in a ring about the central axis (8) and is formed as a convex toroid-like curved support surface.

2. Storage plate holder according to claim 1, **characterised in that** this is fitted with a heating and/or cooling device, preferably a cooling device.

3. Storage plate holder according to claim 1 or 2, **characterised in that** the convex support surface (7) has a curvature (d) in relation to a flat support surface which is in the range of 0.1 mm to 2.0 mm, preferably in the range from 0.5 mm to 1.5 mm.

4. Storage plate holder according to any of the preceding claims, **characterised in that** the clampable outer mask (3) to hold storage plates is formed with an outer diameter (DA) in the range from 20 to 150 mm, preferably diameter 50 to 130 mm.

5. Storage plate holder according to any of the preceding claims, **characterised in that** a ductile and/or elastic contact material is provided at least in part areas on the support surface (7) to enlarge the contact areas between the storage plate (1) and the plate holder (2).

6. Storage plate holder according to claim 5, **characterised in that** the contact material is formed as a film and comprises a plastic and/or a metal.

7. Storage plate holder according to any of the preceding claims, **characterised in that** in the plate holder (2) is provided at least one gas inlet channel (9) for introduction of a contact gas into the intermediate cavity formed by the contact surface (7) and the back of the storage plate (1).

8. Storage plate holder according to claim 7, **characterised in that** annular seals are provided on the contact surface (7) in the region of the outer diameter (D_{A}) and/or in the region of the inner diameter (Dᵢ) of the storage plate (1) in order to seal the intermediate cavity.

9. Use of the storage plate holder according to any of claims 1 to 8, for processing optical storage plates (1), in particular for CDs, CD-R, CD-RW and preferably DVDs, DVD-R and DVD-RW.

10. Use of the storage plate holder according to claim 9 for optical storage plates of plastic, preferably polycarbonate.

## Revendications

1. Support pour un disque mémoire (1) à ouverture centrale (5) destiné à recevoir un traitement de surface dans une installation à vide, dans lequel le support présente une surface d'appui (7) pour le disque (1), laquelle surface (7) comprend un masque externe (3) permettant de bloquer le disque (1) sur sa circonférence contre le support (2), ainsi qu'un masque central (4) de blocage agencé au niveau de l'ouverture (5) du disque, **caractérisé en ce que** la surface d'appui (7) est disposée en anneau autour de l'axe central (8) et constitue une surface bombée convexe toroïdale.

2. Support de disque selon la revendication 1, **caractérisé en ce que** ledit support est équipé d'un dispositif de chauffage et/ou de refroidissement, de préférence d'un dispositif de refroidissement.

3. Support de disque selon la revendication 1 ou 2, **caractérisé en ce que** la surface d'appui (7) convexe présente, par rapport à une surface d'appui plane, un bombement (d) compris entre 0,1 et 2,0 mm, de préférence entre 0,5 et 1,5 mm.

4. Support de disque selon l'une quelconque des revendications précédentes, **caractérisé en ce que** le masque externe (3) est conçu pour recevoir des disques mémoires dont le diamètre extérieur est compris entre 20 et 150 mm, de préférence entre 50 et 130 mm.

5. Support de disque selon l'une quelconque des revendications précédentes, **caractérisé par** un matériau de contact ductile et/ou élastique prévu au moins dans certains secteurs de la surface d'appui (7) afin d'augmenter les surfaces de contact entre le disque (1) et le support de disque (2).

6. Support de disque selon la revendication 5, **caractérisé en ce que** le matériau de contact est une feuille de matière synthétique et /ou de métal.

7. Support de disque selon l'une quelconque des revendications précédentes, **caractérisé par** au moins un canal (9) d'admission de gaz prévu dans le support de disque (2) pour introduire un gaz de contact dans l'espace formé entre la surface d'appui (7) et le dos du disque (1).

8. Support de disque selon la revendication 7, **caractérisé par** des moyens d'étanchéité annulaires disposés sur la surface d'appui (7), au niveau de la circonférence extérieure (diamètre D_{A}) et/ou au niveau de la circonférence intérieure (diamètre D₁) du disque (1), afin d'assurer l'étanchéité dudit espace.

9. Mise en oeuvre d'un support de disque conforme à l'une quelconque des revendications 1 à 8, pour traiter des disques mémoires optiques (1), en particulier des CD, CD-R, CD-RW et, de préférence, des DVD, DVD-R et DVD-RW.

10. Mise en oeuvre du support de disque conforme à la revendication 9, pour traiter des disques mémoires optiques en matière synthétique, de préférence en polycarbonate.
